# EUROPEAN PATENT APPLICATION

(11) **EP 1 675 167 A1**
(43) Date of publication of application: **28.06.2006**
(21) Application number: 05028034.6
(22) Date of filing: 21.12.2005
(51) Int. Cl.: H01L 21/56

(54) **Hot-melt underfill composition and method of application**

(30) Priority: 22.12.2004 US 638337 P; 08.12.2005 US 275080
(71) Applicant: National Starch and Chemical Investment Holding Corporation, New Castle, Delaware 19720 (US)
(72) Inventor: Chaware, Raghunandan Ramesh, Huntington Beach 92646 California (US); He, Xiping, Cerritos 90703 California (US); Shenfield, David, Fountain Valley 92703 California (US)
(74) Representative: Held, Stephan

(57) **Abstract**

This invention provides a process for applying a wafer level underfill comprising: providing a solvent-free hot-melt underfill composition; melting the underfill; applying the underfill in a uniform layer to the active side of a semiconductor wafer; returning the underfill to a solid state; optionally B-staging the underfill; optionally removing any excess underfill from the bumps on the wafer; and dicing the wafer into individual dies.

## Description

**FIELD OF THE INVENTION**

This invention relates to a hot-melt solvent-free underfill composition and the method of depositing that underfill, particularly onto a silicon semiconductor wafer before it is singulated into individual dies.

**BACKGROUND OF THE INVENTION**

In the construction of semiconductor assemblies, semiconductor dies or chips are both electrically and mechanically attached to substrates. In one method of attach, the face of the die containing electrical terminal pads and circuitry, the active face, is bumped with deposits of solder. These solder bumps are aligned and contacted with corresponding terminals on the substrate, the solder is heated to its melting point or "reflow" temperature to form solder joints, enabling mechanical support and electrical interconnections between the semiconductor die and the substrate.

Differences between the coefficient of thermal expansion (CTE) of the die and the substrate often require that the space between the die and the substrate be filled with a reinforcing material, commonly known as underfill, to absorb the stresses created by the CTE differential. Such underfill materials are applied commonly using at least three different methods.

In the method known as "capillary flow", the semiconductor die is attached to the substrate through solder interconnections, and then an underfill material is dispensed around the edges of the gap existing between the semiconductor die and the substrate. The underfill is drawn into the gap by capillary action and then cured.

In the method known as "no flow", the underfill material is dispensed onto a substrate and the semiconductor chip or die is placed onto the substrate. Placement is made such that the solder bumps on the chip are in contact with the corresponding pads on the substrate before the connection by solder reflow. Typically, the underfill is cured during the solder reflow step, though sometimes an additional cure step is required. No flow assembly can also be performed using thermocompression bonding. In this method, the no flow underfill is dispensed on the substrate, the die is placed on the substrate and heat and pressure are applied to the die and/or the substrate to achieve reflow as well as interconnection. As the pressure and heat are applied, the underfill flows out to form fillets and also allows the solder bumps to make interconnection with the pads. The underfill may require an additional cure step.

Capillary and no flow underfill methods are time-consuming due to the fact that they are conducted at the die level. Another major drawback of the no flow system is that if the no flow underfill is a filled system, then filler can interfere with soldering. In addition, the no flow method would require new industry infrastructure to support the thermal compression bonding required, instead of the processes using surface mount technology infrastructure that are standard today.

A third method known as "pre-applied" involves applying the underfill onto the active side of a full silicon wafer that has been bumped with solder, and singulating the wafer into individual dies at that stage. Such wafer-applied underfills and underfill methods are capable of using standard surface mount technology, improve processing speeds, and thus also reduce processing costs.

In the main, existing pre-applied undefills rely on solvent-based adhesive systems in which the solvent must be removed and/or the underfill partially cured to form a solid layer. This process, removing solvent and/or partially curing, is known as B-staging. After the underfill is B-staged, the wafer is diced into individual chips. Alternatively a back grinding process to thin the silicon to a controlled thickness may precede the singulation process. The solder balls on the active face are aligned with the terminals on the substrate and the chip is placed on the substrate. The solder is reflowed to form electrical interconnection. If the underfill is not completely cured during solder reflow, a separate underfill cure step may follow.

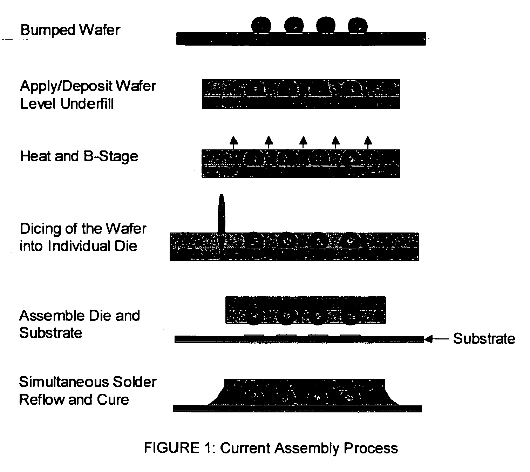

The current process employed for the assembly of die with wafer level underfill is shown in FIGURE 1. Although this wafer level process has advantages over capillary flow and no-flow, it does have some disadvantages. If the B-stage conditions are not optimized, residual solvent in the wafer level underfill can outgas during reflow, impeding good solder connections (leading to cold solder joints), or causing voids, which can lead potentially to failed devices, or causing areas that are not contacted by the underfill (non-wets). Further, as the thickness of the underfill layer increases beyond 200 micrometers, removal of solvent from the underfill becomes very difficult. The residual solvent outgases during reflow, causing voids and non-wets. Solvent removal is an additional step in the process and the removed solvent must be disposed of in an environmentally conscious way.

**SUMMARY OF THE INVENTION**

This invention provides a solution to the above problems by providing a solvent-free curable hot-melt composition, methods for making such hot-melt compositions suitable for use as wafer level underfills, and an application method for depositing or applying the hot-melt underfill onto a semiconductor wafer. A hot-melt composition is a solid at room temperature, but melts and flows at elevated temperatures.

Inasmuch as no solvent is required, voiding or non-wets due to solvent outgassing during reflow are avoided. The underfill layer thickness can be any effective thickness as required for the particular process as determined by the practitioner. Thick layers of underfill can be used (>200 µm), if necessary, to accommodate higher solder bump configurations. There is significant reduction in cycle time, as any B-stage process can be very short. There is no need to process or dispose of solvent. The application is performed at the wafer level, increasing manufacturing efficiency compared with die-level underfill application. No new significant equipment infrastructure is required.

**BRIEF DESCRIPTION OF THE FIGURES**

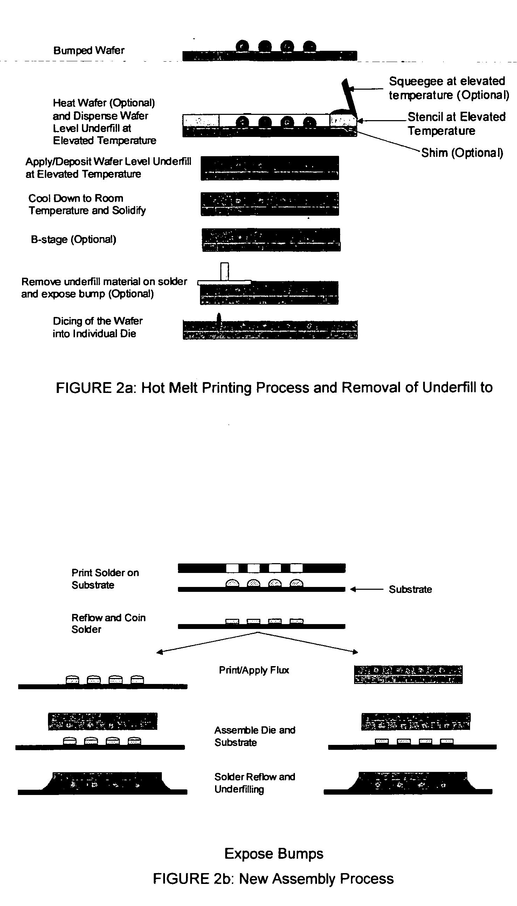

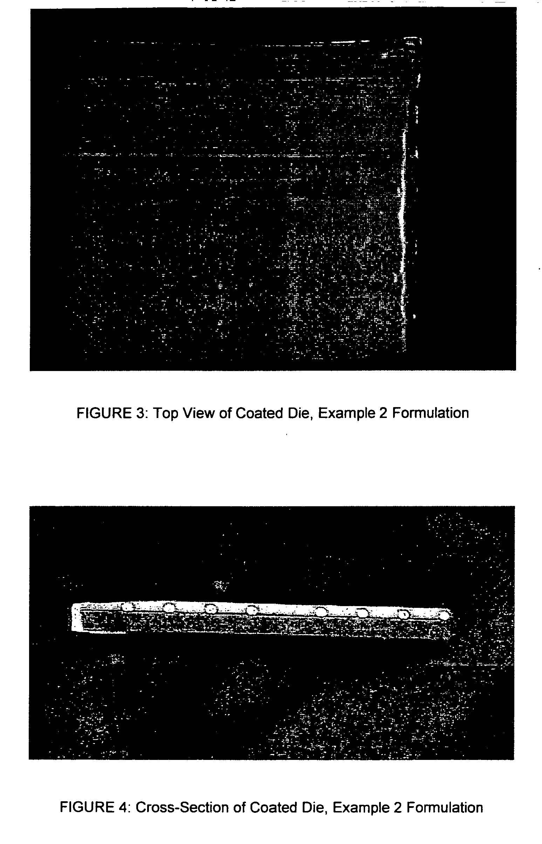

Figure 1 is a diagram of the current process employed for the assembly of die with wafer level underfill. Figures 2a and 2b are diagrams of the underfill process of the invention. Figure 3 is a photo of a bumped die coated with the wafer level underfill. Figure 4 is a photo of a cross-section of a bumped die coated with the wafer level underfill.

**DETAILED DESCRIPTION OF THE INVENTION**

The hot-melt underfill compositions of this invention comprise one or more curable or polymerizable and polymerized materials, such as monomer, pre-polymer and thermoplastic, that are solid at room temperature and become a liquid within the temperature range of 40°C and 300°C. In another embodiment, the hot-melt compositions can be prepared from liquid resins that are solidified by extrusion or spray-drying techniques known to those with expertise in the hot-melt technology.

Before solder connection, these materials should be able to melt during reflow (solder connection) process. But after solder connection, these materials could be either be reworkable or non-reworkable depending on the specific package and/or the end application. If the desired end application requires reworking ability in the material, then the material will become soft and have minimal adhesion at and above temperatures higher than melting temperature of the solder allowing easy removal of material as well as solder. If the end application does not require the material to be reworkable, then the material will hold its shape and strength even at high temperature, and will not be reworkable.

The polymer will be the major component in the composition, excluding any fillers present. Other components, typically used in underfill compositions, may be added at the option of the practitioner; such other components include, but are not limited to, curing agents, fluxing agents, wetting agents, flow control agents, adhesion promoters, and air release agents. The compositions may also contain filler, in which case the filler will be present in an amount up to 95% of the total composition.

A primary characteristic of these materials is that they have sufficient solidity to be capable of being diced. Therefore, after the application of the underfill to the semiconductor wafer, the wafer can be singulated into individual dies by any standard semiconductor sawing equipment without sticking to the blade.

One way to obtain sufficient solidity is by choosing a resin that is solid at room temperature and can withstand the heat generated during various fabrication operations such as the dicing operation. This also prevents the resin/underfill from sticking to the blade. Another way to obtain sufficient solidity is to B-stage the underfill, which advances the resin to such an extent that it can withstand the heat generated during dicing and will not deform. The extent of B-staging is controlled by choosing an appropriate latent catalyst. Depending on the end application, the underfill may be composed so that it is reworkable; that is, the underfill would have minimal adhesion at the solder liquidus temperature. Suitable materials are those that are solids at room temperature and that have a melting point in a working temperature range.

Suitable polymers for the underfill composition include thermosets and thermoplastics including epoxy, polyamide, phenoxy, polybenzoxazine, acrylate, cyanate ester, bismaleimide, polyether sulfone, polyimide, benzoxazine, vinyl ether, siliconized olefin, polyolefin, polybenzoxyzole, polyester, polystyrene, polycarbonate, polypropylene, poly(vinyl chloride), polyisobutylene, polyacrylonitrile, poly(methyl methacrylate), poly(vinyl acetate), poly(2-vinylpridine), cis-1,4-polyisoprene, 3,4-polychloroprene, vinyl copolymer, poly(ethylene oxide), poly(ethylene glycol), polyformaldehyde, polyacetaldehyde, poly(b-propiolacetone), poly(10-decanoate), poly(ethylene terephthalate), polycaprolactam, poly(11-undecanoamide), poly(m-phenylene-terephthalamide), poly(tetramethlyene-m-benzenesulfonamide), polyester polyarylate, poly(phenylene oxide), poly(phenylene sulfide), polysulfone, polyimide, polyetheretherketone, polyetherimide, fluorinated polyimide, polyimide siloxane, poly-iosindolo-quinazolinedione, polythioetherimide poly-phenyl-quinoxaline, polyquuinixalone, imide-aryl ether phenylquinoxaline copolymer, polyquinoxaline, polybenzimidazole, polybenzoxazole, polynorbornene, poly(arylene ethers), polysilane, parylene, benzocyclobutenes, hydroxy(benzoxazole) copolymer, poly(silarylene siloxanes), and polybenzimidazole.

The polymer will be the major component in the composition, excluding any fillers present. In general, if a filler is present, the filler will be present in an amount up to about 95% of the total composition.

Other suitable materials for making hot-melt compositions include rubber polymers such as block copolymers of monovinyl aromatic hydrocarbons and conjugated diene, e.g., styrene-butadiene, styrene-butadiene-styrene (SBS), styrene-isoprene-styrene (SIS), styrene-ethylene-butylene-styrene (SEBS), and styrene-ethylene-propylene-styrene (SEPS).

Other suitable materials for making hot-melt compositions include ethylene-vinyl acetate polymers, other ethylene esters and copolymers, e.g., ethylene methacrylate, ethylene n-butyl acrylate and ethylene acrylic acid; polyolefins such as polyethylene and polypropylene; polyvinyl acetate and random copolymers thereof; polyacrylates; polyamides; polyesters; and polyvinyl alcohols and copolymers thereof.

In some embodiments these compositions are formulated with tackifying resins in order to improve adhesion and introduce tack; examples of tackifying resins include naturally-occurring resins and modified naturally-occurring resins; polyterpene resins; phenolic modified terpene resins; coumarons-indene resins; aliphatic and aromatic petroleum hydrocarbon resins; phthalate esters; hydrogenated hydrocarbons, hydrogenated rosins and hydrogenated rosin esters.

In some embodiments other components may be included, for example, diluents such as liquid polybutene or polypropylene; petroleum waxes such as paraffin and microcrystalline waxes, polyethylene greases, hydrogenated animal, fish and vegetable fats, mineral oil and synthetic waxes, naphthenic or paraffinic mineral oils.

Other optional additives may include stabilizers, antioxidants, colorants and fillers.

In one embodiment, solid aromatic bismaleimide (BMI) resin powders form the major portion of the underfill resin. Suitable solid BMI resins are those having the structure 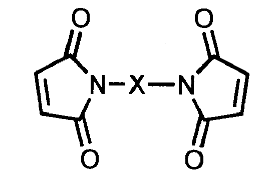 in which X is an aromatic group; exemplary aromatic groups include: 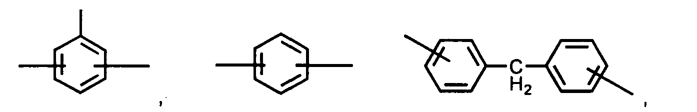 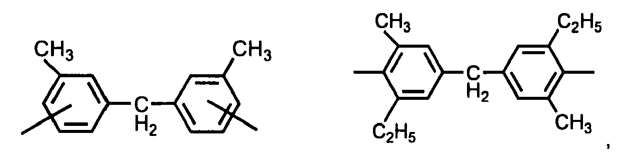 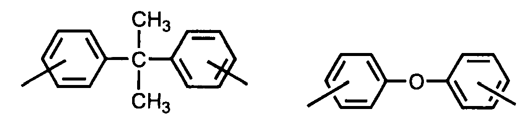 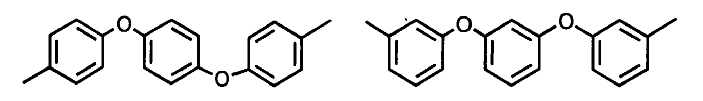 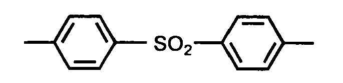 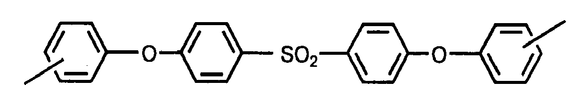 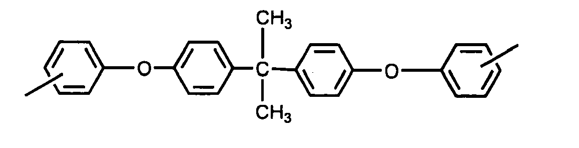 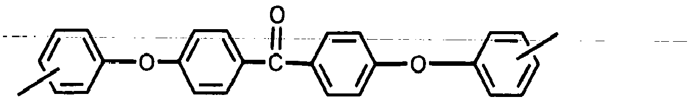 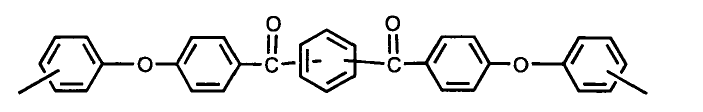 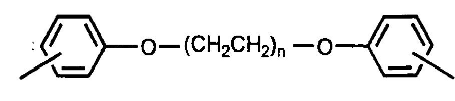 in which n is 1 - 3,

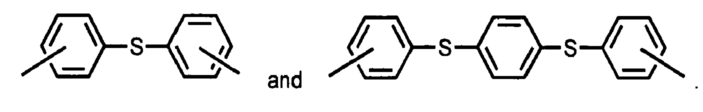

Bismaleimide resins having these X bridging groups are commercially available, and can be obtained, for example, from Sartomer (USA) or HOS-Technic GmbH (Austria).

It is preferable to utilize solid resins, as liquid resins usually do not provide tack free surface without being completely cured. However, a combination of solid resin and liquid resin can be used, where the liquid resin is present at a level of 40% by weight or less of the total resin.

Alternatively, the curable resin may be in liquid form that is later solidified before being used in the inventive compositions. Suitable resins that are available in liquid form include epoxies, acrylates or methacrylates, maleimides, vinyl ethers, polyesters, poly(butadienes), siliconized olefins, silicone resins, styrene resins and cyanate ester resins.

In another embodiment, maleimide resins can be used in the inventive hot melt composition and include those having the generic structure 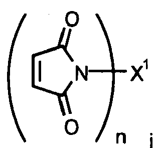 in which n is 1 to 3 and X¹ is an organic moiety containing aliphatic or aromatic groups. Exemplary X¹ entities include, poly(butadienes), poly(carbonates), poly(urethanes), poly(ethers), poly(esters), simple hydrocarbons, and simple hydrocarbons containing functionalities such as carbonyl, carboxyl, amide, carbamate, urea, or ether. These types of resins are commercially available and can be obtained, for example, from National Starch and Chemical Company and Dainippon Ink and Chemical, Inc.

In a further embodiment, the maleimide resins are selected from the group consisting of 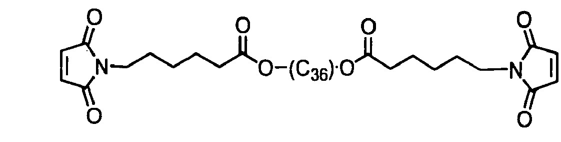 in which C₃₆ represents a linear or branched chain (with or without cyclic moieties) of 36 carbon atoms; 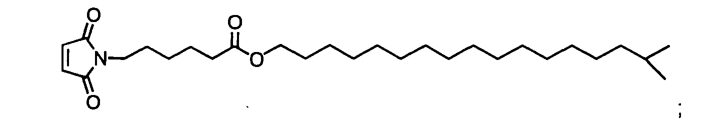 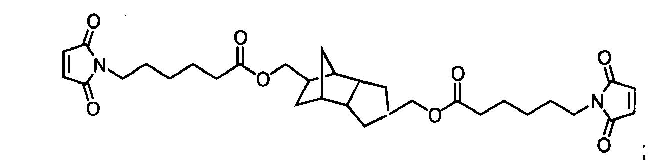 and

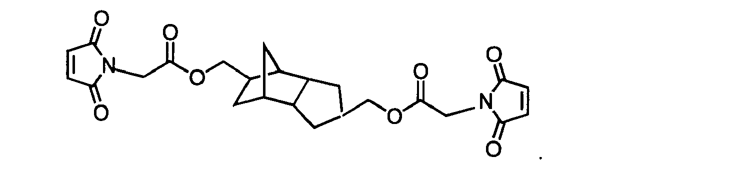

Suitable acrylate resins include those having the generic structure 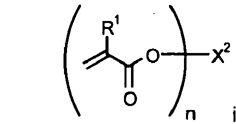 in which n is 1 to 6, R¹ is -H or -CH₃. and X² is an organic moiety containing aromatic or aliphatic groups. Exemplary X² entities include poly(butadienes), poly(carbonates), poly(urethanes), poly(ethers), poly(esters), simple hydrocarbons, and simple hydrocarbons containing functionalities such as carbonyl, carboxyl, amide, carbamate, urea, or ether. Commercially available materials include butyl (meth)acrylate, isobutyl (meth)acrylate, 2-ethyl hexyl (meth)acrylate, isodecyl (meth)acrylate, n-lauryl (meth)acrylate, alkyl (meth)acrylate, tridecyl (meth)acrylate, n-stearyl (meth)acrylate, cyclohexyl(meth)acrylate, tetrahydrofurfuryl(meth)acrylate, 2-phenoxy ethyl(meth)acrylate, isobornyl(meth)acrylate, 1,4-butanediol di(meth)acrylate, 1.6 hexanediol di(meth)acrylate, 1,9-nonandiol di(meth)acrylate, perfluorooctylethyl (meth)acrylate, 1,10 decandiol di(meth)acrylate, nonylphenol polypropoxylate (meth)acrylate, and polypentoxylate tetrahydrofurfuryl acrylate, available from Kyoeisha Chemical Co., LTD; polybutadiene urethane dimethacrylate (CN302, NTX6513) and polybutadiene dimethacrylate (CN301, NTX6039, PRO6270) available from Sartomer Company, Inc; polycarbonate urethane diacrylate (ArtResin UN9200A) available from Negami Chemical Industries Co., LTD; acrylated aliphatic urethane oligomers (Ebecryl 230, 264, 265, 270,284, 4830, 4833, 4834, 4835, 4866, 4881, 4883, 8402, 8800-20R, 8803, 8804) available from Radcure Specialities, Inc; polyester acrylate oligomers (Ebecryl 657, 770, 810, 830, 1657, 1810, 1830) available from Radcure Specialities, Inc.; and epoxy acrylate resins (CN104, 111, 112, 115, 116, 117, 118, 119, 120, 124, 136) available from Sartomer Company, Inc. In one embodiment the acrylate resins are selected from the group consisting of isobornyl acrylate, isobornyl methacrylate, lauryl acrylate, lauryl methacrylate, poly(butadiene) with acrylate functionality and poly(butadiene) with methacrylate functionality.

Suitable vinyl ether resins include those having the generic structure 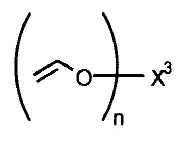 in which n is 1 to 6 and X³ is an organic moiety containing aromatic or aliphatic groups. Exemplary X³ entities include poly(butadienes), poly(carbonates), poly(urethanes), poly(ethers), poly(esters), simple hydrocarbons, and simple hydrocarbons containing functionalities such as carbonyl, carboxyl, amide, carbamate, urea, or ether. Commercially available resins include cyclohenanedimethanol divinylether, dodecylvinylether, cyclohexyl vinylether, 2-ethylhexyl vinylether, dipropyleneglycol divinylether, hexanediol divinylether, octadecylvinylether, and butandiol divinylether available from International Speciality Products (ISP); Vectomer 4010, 4020, 4030, 4040, 4051, 4210, 4220, 4230, 4060, 5015 available from Sigma-Aldrich, Inc.

Suitable poly(butadiene) resins include poly(butadienes), epoxidized poly(butadienes), maleic poly(butadienes), acrylated poly(butadienes), butadiene-styrene copolymers, and butadiene-acrylonitrile copolymers. Commercially available materials include homopolymer butadiene (Ricon130, 131, 134, 142, 150, 152, 153, 154, 156, 157, P30D) available from Sartomer Company, Inc; random copolymer of butadiene and styrene (Ricon 100, 181, 184) available from Sartomer Company Inc.; maleinized poly(butadiene) (Ricon 130MA8, 130MA13, 130MA20, 131MA5, 131MA10, 131MA17, 131MA20, 156MA17) available from Sartomer Company, Inc.; acrylated poly(butadienes) (CN302, NTX6513, CN301, NTX6039, PRO6270, Ricacryl 3100, Ricacryl 3500) available from Sartomer Inc.; epoxydized poly(butadienes) (Polybd 600, 605) available from Sartomer Company. Inc. and Epolead PB3600 available from Daicel Chemical Industries, Ltd; and acrylonitrile and butadiene copolymers (Hycar CTBN series, ATBN series, VTBN series and ETBN series) available from Hanse Chemical.

Suitable epoxy resins include bisphenol, naphthalene, and aliphatic type epoxies. Commercially available materials include bisphenol type epoxy resins (Epiclon 830LVP, 830CRP, 835LV, 850CRP) available from Dainippon Ink & Chemicals, Inc.; naphthalene type epoxy (Epiclon HP4032) available from Dainippon Ink & Chemicals, Inc.; aliphatic epoxy resins (Araldite CY179, 184, 192, 175, 179) available from Ciba Specialty Chemicals, (Epoxy 1234, 249, 206) available from Union Carbide Corporation, and (EHPE-3150) available from Daicel Chemical Industries, Ltd. Other suitable epoxy resins include cycloaliphatic epoxy resins, bisphenol-A type epoxy resins, bisphenol-F type epoxy resins, epoxy novolac resins, biphenyl type epoxy resins, naphthalene type epoxy resins, dicyclopentadienephenol type epoxy resins,

Suitable siliconized olefin resins are obtained by the selective hydrosilation reaction of silicone and divinyl materials, having the generic structure, 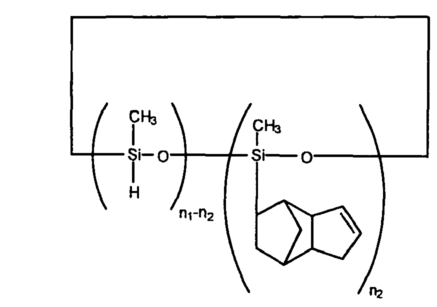 in which n₁ is 2 or more, n₂ is 1 or more and n₁>n₂. These materials are commercially available and can be obtained, for example, from National Starch and Chemical Company.

Suitable silicone resins include reactive silicone resins having the generic structure 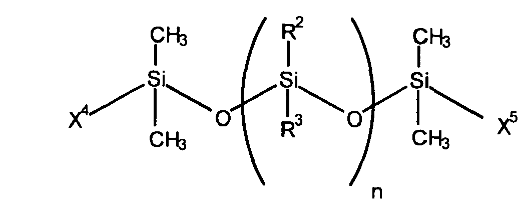 in which n is 0 or any integer, X⁴ and X⁵ are hydrogen, methyl, amine, epoxy, carboxyl, hydroxy, acrylate, methacrylate, mercapto, phenol, or vinyl functional groups, R² and R³ can be -H, -CH₃, vinyl, phenyl, or any hydrocarbon structure with more than two carbons. Commercially available materials include KF8012, KF8002, KF8003, KF-1001, X-22-3710, KF6001, X-22-164C, KF2001, X-22-170DX, X-22-173DX, X-22-174DX X-22-176DX, KF-857, KF862, KF8001, X-22-3367, and X-22-3939A available from Shin-Etsu Silicone International Trading (Shanghai) Co., Ltd.

Suitable styrene resins include those resins having the generic structure 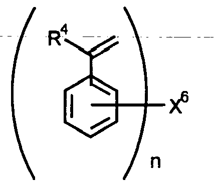 in which n is 1 or greater, R⁴ is -H or -CH₃, and X⁶ is an aliphatic group. Exemplary X⁶ entities include poly(butadienes), poly(carbonates), poly(urethanes), poly(ethers), poly(esters), simple hydrocarbons, and simple hydrocarbons containing functionalities such as carbonyl, carboxyl, amide, carbamate, urea, or ether. These resins are commercially available and can be obtained, for example, from National Starch and Chemical Company or Sigma-Aldrich Co.

Suitable cyanate ester resins include those having the generic structure 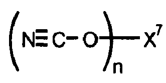 in which n is 1 or larger, and X⁷ is an organic moiety containing hydrocarbon and aromatic groups. Exemplary X⁷ entities include bisphenol, phenol or cresol novolac, dicyclopentadiene, polybutadiene, polycarbonate, polyurethane, polyether, or polyester. Commercially available materials include; AroCy L-10, AroCy XU366, AroCy XU371, AroCy XU378, XU71787.02L, and XU 71787.07L, available from Huntsman LLC; Primaset PT30, Primaset PT30 S75, Primaset PT60, Primaset PT60S, Primaset BADCY, Primaset DA230S, Primaset MethylCy, and Primaset LECY, available from Lonza Group Limited; 2-allyphenol cyanate ester, 4-methoxyphenol cyanate ester, 2,2-bis(4-cyanatophenol)-1,1,1,3,3,3-hexafluoropropane, bisphenol A cyanate ester, diallylbisphenol A cyanate ester, 4-phenylphenol cyanate ester, 1,1,1-tris(4-cyanatophenyl)ethane, 4-cumylphenol cyanate ester, 1,1-bis(4-cyanateophenyl)ethane, 2,2,3,4,4,5,5,6,6,7,7-dodecafluoro-octanediol dicyanate ester, and 4,4'-bisphenol cyanate ester, available from Oakwood Products, Inc.

If curing agent is required, its selection is dependent on the polymer chemistry used and the processing conditions employed. The curing agent must be sufficiently inactive at processing and storage conditions (underfill formulation and mixing, application to the wafer, and storage prior to die attach) to prevent excessive advancement of the resin material. Such curing agents are often referred to as latent catalysts. Excessive advancement causes the viscosity of the underfill system to become too high for application to the wafer and/or for effective bonding of the semiconductor die to the substrate.

As curing agents, the compositions may use aromatic amines, alicyclic amines, aliphatic amines, triazines, metal salts, aromatic hydroxyl compounds. Examples of such catalysts include imidazoles, such as 2-methylimidazole, 2-undecylimidazole, 2-heptadecyl imidazole, 2-phenylimidazole, 2-ethyl 4-methylimidazole, 1-benzyl-2-methylimidazole, 1-propyl-2-methylimidazole, 1-cyanoethyl-2-methylimidazole, 1-cyanoethyl-2-ethyl-4-methylimidazole, 1-cyanoethyl-2-undecylimidazole, 1-cyanoethyl-2-phenylimidazole, 1-guanaminoethyl-2-methylimidazole and addition product of an imidazole and trimellitic acid; tertiary amines, such as N,N-dimethyl benzylamine, N,N-dimethylaniline, N,N-dimethyltoluidine, N,N-dimethyl-p-anisidine, p-halogeno-N,N-dimethylaniline, 2-N-ethyl-anilino ethanol, tri-n-butylamine, pyridine, quinoline, N-methylmorpholine, triethanolamine, triethylenediamine, N,N,N',N'-tetramethylbutanediamine, N-methylpiperidine; phenols, such as phenol, cresol, xylenol, resorcine, and phloroglucin; organic metal salts, such as lead naphthenate, lead stearate, zinc naphthenate, zinc octolate, tin oleate, dibutyl tin maleate, manganese naphthenate, cobalt naphthenate, and acetyl aceton iron; and inorganic metal salts, such as stannic chloride, zinc chloride and aluminum chloride; peroxides, such as benzoyl peroxide, lauroyl peroxide, octanoyl peroxide, acetyl peroxide, para-chlorobenzoyl peroxide and di-t-butyl diperphthalate; acid anhydrides, such as maleic anhydride, phthalic anhydride, lauric anhydride, pyromellitic anhydride, trimellitic anhydride, hexahydrophthalic anhydride; hexahydropyromellitic anhydride and hexahydrotrimellitic anhydride, azo compounds, such as azoisobutylonitrile, 2,2'-azobispropane, m,m'-azoxystyrene, hydrozones, and mixtures thereof.

The curing agent can be either a free radical initiator or cationic initiator, depending on whether a radical or ionic curing resin is chosen. If a free radical initiator is used, it will be present in an effective amount. An effective amount typically is 0.1 to 10 percent by weight of the organic compounds (excluding any filler). Preferred free-radical initiators include peroxides, such as butyl peroctoates and dicumyl peroxide, and azo compounds, such as 2,2'-azobis(2-methyl-propanenitrile) and 2,2'-azobis(2-methyl-butanenitrile).

If a cationic initiator is used, it will be present in an effective amount. An effective amount typically is 0.1 to 10 percent by weight of the organic compounds (excluding any filler). Preferred cationic curing agents include dicyandiamide, phenol novolak, adipic dihydrazide, diallyl melamine, diamino malconitrile, BF3-amine complexes, amine salts and modified imidazole compounds.

In one embodiment, a curing accelerator may be used to supplement the curing agent, in which case, preferred accelerators are selected from the group consisting of triphenylphosphine, alkyl-substituted imidazoles, imidazolium salts, onium. borates, metal chelates, or a mixture thereof.

Metal compounds also can be employed as cure accelerators for cyanate ester systems and include, but are not limited to, metal napthenates, metal acetylacetonates (chelates), metal octoates, metal acetates, metal halides, metal imidazole complexes, and metal amine complexes.

In some cases, it may be desirable to use more than one type of cure. For example, both cationic and free radical initiation may be desirable, in which case both free radical cure and ionic cure resins can be used in the composition. Such a composition would permit, for example, the curing process to be started by cationic initiation using UV irradiation, and in a later processing step, to be completed by free radical initiation upon the application of heat

Preferably, curing should take place during reflow. However, if the curing is not enough, and if the underfill does not have enough strength and structure, a curing step after reflow will be required to advance the reaction further. Even if there is no curing after reflow, a curing agent may still be used. For example, in some instances the time and temperature during may not allow all the reaction to occur. In that case, a separate curing step may be required.

If a curing step is utilized, the cure temperature will generally be within a range of 80°-250°C, and curing will be effected within a time period ranging from few seconds or up to 120 minutes, depending on the particular resin chemistry and curing agents chosen. The time and temperature curing profile for each adhesive composition will vary, and different compositions can be designed to provide the curing profile that will be suited to the particular industrial manufacturing process.

Depending on the end application, one or more fillers may be included in the composition and usually are added for improved rheological properties and stress reduction. For underfill applications the filler will be electrically nonconductive. Examples of suitable nonconductive fillers include alumina, aluminum hydroxide, silica, vermiculite, mica, wollastonite, calcium carbonate, titania, sand, glass, barium sulfate, zirconium, carbon black, organic fillers, and halogenated ethylene polymers, such as, tetrafluoroethylene, trifluoroethylene, vinylidene fluoride, vinyl fluoride, vinylidene chloride, and vinyl chloride. The filler particles may be of any appropriate size ranging from nano size to several mm. The choice of such size for any particular end use is within the expertise of one skilled in the art. Filler may be present in an amount from 0 to 95% by weight of the total composition.

Depending on the end application, a fluxing agent may be included in the composition. Fluxing agent selection will depend on the resin chemistry utilized. However, some of the key requirements of the fluxing agent are that it should not affect the curing of epoxy, should not be too corrosive, should not outgass too much during reflow, should be compatible with the resin, and/or the flux residues should be compatible with the resin.

Examples of suitable fluxing agents include compounds that contain one or more hydroxyl groups (-OH), such as organic carboxylic acids, anhydrides, and alcohols, for example, hexahydrophthalic anhydride, methyl hexahydrophthalic anhydride, ethylene glycol, glycerol, 3-[bis(glycidyl oxy methyl)methoxy]-1,2- propane diol. D-ribose, D-cellobiose, cellulose, and 3-cyclohexene-I,I- dimethanol; amine fluxing agents, such as, aliphatic amines having 1-10 carbon atoms, e.g., trimethylamine, triethylamine, n- propylamine, n-butylamine, isobutylamine, sec-butylamine, t-butylamine, n- amylamine, sec-amylamine, 2-ethylbutylamine, n-heptylamine, 2- ethylhexylamine, n-octylamine, and t- octylamine; epoxy resins employing a cross-linking agent with fluxing properties. Fluxing agents will be present in an effective amount; a typical effective amount ranges from 1 to 30% by weight.

In another embodiment, a coupling agent may be added to the composition. Typically, coupling agents are silanes, for example, epoxy-type silane coupling agent, amine-type silane coupling agent, or mercapto-type silane coupling agent. Coupling agents, if used, will be used in an effective amount; a typical effective amount is an amount up to 5% by weight.

In a further embodiment, a surfactant may be added to the composition. Suitable surfactants silicones, polyoxyethylene/ polyoxypropylene block copolymers, ethylene diamine based polyoxy-ethylene/polyoxypropylene block copolymers, polyol-based polyoxyalkylenes, fatty alcohol-based polyoxyalkylenes, and fatty alcohol polyoxyalkylene alkyl ethers. Surfactants, if used, will be used in an effective amount; a typical effective amount is an amount up to 5% by weight.

Depending on the process conditions employed, a wetting agent may be included in the composition. Wetting agent selection will depend on the application requirements and the resin chemistry utilized. Wetting agents, if used, will be used in an effective amount: a typical effective amount is an amount up to 5% by weight. Examples of suitable wetting agents include Fluorad FC-4430 Fluorosurfactant available from 3M, Clariant Fluowet OTN, BYK W-990, Surfynol 104 Surfactant, Crompton Silwet L-7280, Triton X100 available from Rhom and Haas, propylene glycol with a preferable Mw greater than 240, gamma-butyrolactone, castor oil, glycerin or other fatty acids, and silanes.

Depending on the process conditions employed, a flow control agent may be included in the composition. Flow control agent selection will depend on the application requirements and resin chemistry employed. Flow control agents, if used, will be present in an effective amount; a typical effective amount is an amount up to 5% by weight. Examples of suitable flow control agents include Cab-O-Sil TS720 available from Cabot, Aerosil R202 or R972 available from Degussa, fumed silicas, fumed aluminas, or fumed metal oxides.

Depending on the end application and resin chemistry used, an adhesion promoter may be included in the composition. Adhesion promoter selection will depend on the application requirements and resin chemistry employed. Adhesion promoters, if used, will be used in an effective amount; a typical effective amount is an amount up to 5% by weight. Examples of suitable adhesion promoters include: Z6040 epoxy silane or Z6020 amine silane available from Dow Corning; A186 Silane, A187 Silane, A174 Silane, or A1289 available from OSI Silquest; Organosilane S1264 available from Degussa; Johoku Chemical CBT-1 Carbobenzotriazole available from Johoku Chemical; functional benzotriazoles; thiazoles.

Depending on the underfill manufacturing method and application method utilized, an air release agent (defoamer) may be utilized. Air release agent selection will depend on the application requirements and resin chemistry employed. Air release agents, if used, will be used in an effective amount: a typical effective amount will be an amount up to 5% by weight. Examples of suitable air release agents include Antifoam 1400 available from Dow Corning, DuPont Modoflow, and BYK A-510.

Other additives, such as diluents, stablizers, and impact modifiers, in types and amounts known in the art, may also be added.

In a further embodiment, this invention is a process for making semiconductor chips on which is applied an underfill composition. The process comprises: providing a hot-melt underfill composition, heating the underfill to a temperature above its melting temperature until it is molten, applying the molten underfill in a uniform layer to the active side of a semiconductor wafer, cooling the underfill to return it to a solid state, optionally B-staging the underfill (heating to remove solvent or solidify it), optionally removing any excess underfill from the bumps on the wafer, and dicing the wafer into individual dies.

The underfill process of this invention is shown in Figure 2a and Figure 2b.

The step of heating the underfill above the melting point of the composition to enable molten coating of the underfill onto the wafer may be a separate step or an integrated part of the fabrication process and will depend on the application method to be employed. The fabrication method employed must be capable of distributing the molten underfill onto the wafer in a layer that is substantially uniform in thickness and in composition. The application of the molten underfill composition in a uniform layer can be accomplished by one or more techniques. The usual techniques include stencil printing, screen printing, "hot melt" printing, jetting, spin coating, powder coating, injection molding, transfer molding, and film lamination. Depending on the application method used the wafer may be at room temperature or heated to a temperature between room temperature and the application temperature of the adhesive.

Solidification of the underfill will be accomplished through the cooling of the coated wafer below the melting point of the underfill, by exposing it to ambient conditions or a cooled environment.

Depending on the resin formulation utilized, to minimize tackiness of the underfill after solidification there could optionally be included a separate B-staging operation in which the polymer is partially cured. B-staging conditions would depend on the resin formulation utilized and the degree of cure desired. Generally B-staging conditions would occur at a temperature or a temperature range between 50° to175°C for a period of time between 5 seconds to 120 minutes.

If the underfill is coated onto the wafer at a height above that of the bumps, it is necessary to remove the excess underfill from the bumps so that they can wet the terminals on the substrate to form electrical interconnections. This removal can be accomplished through a number of methods known in the art including mechanical abrasion. Another possible method of underfill removal is chemical etching, where the underfill material on the top of the bumps is preferentially removed/etched by using a suitable solvent. The choice of solvent will depend on the type of resin used. A process combining the mechanical grinding and chemical etching process can also be used to remove the underfill on top of the bumps. Another potential method is by plasma cleaning.

Wafer dicing is accomplished using standard dicing techniques and equipment known to those skilled in the art.

This process can be used with any bump or stud metallurgy including, for example, tin-lead eutectic, lead-free (Sn/Ag/Cu, Sn/Ag, Sn/Cu), copper, gold, Au/Sn, Au/Ge or indium.

In another embodiment, this invention is a process for making the hot-melt underfill composition. The underfill composition is manufactured using any process capable of mixing the resin and any other ingredients above the melting temperature of the resin. Preferably the components of the composition are added so that the curing agent is added at a time in the processing at which it will not cause the composition to advance. In general, it is desired to control the length of time any curing agents present are exposed to elevated temperatures. This allows the degree of cure, or advancement, of the resin to be controlled within appropriate limits for the application.

The manufacturing method must also include the capability for "degassing" or removing any gas generated or possibly entrapped in the adhesive composition during mixing. Degassing can be done by applying vacuum during mixing.

Examples of suitable manufacturing methods include high shear mixing of the components followed by grinding of the solid composition, and single or twin screw extrusion of a liquid into solid pellets.

**EXAMPLES**

Dies were prepared according to the inventive process. Two different underfill formulations were prepared, and are presented as Examples 1 and 2.

EXAMPLE 1

The EXAMPLE 1 formulation was prepared using standard adhesive mixing techniques known to those skilled in the art, with the following composition:

| | |
|---|---|
| Epon 1001 F Bisphenol A/Epichlorohydrin Epoxy | 47.6 wt% |
| Amorphous Silica Filler | 47.6 wt% |
| Polysebacic Polyanhydride | 4.76 wt% |

EXAMPLE 2

The EXAMPLE 2 formulation was prepared using standard adhesive mixing techniques known to those skilled in the art, with the following composition:

| | |
|---|---|
| Epiclon HP-7200H Epoxy Resin | 41.7 wt% |
| Amorphous Silica Filler | 41.7 wt% |
| Dodecanedioic Acid Flux | 10.0 wt% |
| Epiclon 830S Bisphenol F Epoxy | 4.17 wt% |
| Hypox RM20 Rubber Modified Epoxy | 1.9 wt% |
| HRJ 1166 Novolac Phenol Resin | 0.48 wt% |
| Amino Aromatic Amide | 0.11 wt% |

Each composition was separately printed onto a silicon wafer that had 450 micron high bumps at 800 micron pitch. An aluminum stencil that was slightly thicker than the bumped wafer was used for printing, so that the material would fully cover the bumps. This ensured that the bumps were not damaged by the squeegee during printing. The wafer was placed inside the stencil on a hot plate. An excess amount of solid underfill was placed on the hot plate, at one end of the stencil and wafer. The stencil, wafer, and solid underfill were heated to 130°C, at which point the underfill was molten. The underfill was then printed on the wafer through the stencil using a metal squeegee. After printing, the coated wafer was allowed to cool to room temperature. At room temperature, the wafer level underfill became solid and was diced into individual dies using DAD320 Disco sawing equipment with the following dicing parameters: Saw type - NBC-ZH 2050-SE 27 HEEE
Sharp hub edge type
Saw outer diameter - 55.56 mm
Saw inner diameter - 19.05 mm
Exposure - 0.890-1.020 mm
Kerf width - 0.035 - 0.040 mm
Cutting depth - 0.8382 mm
Spindle Revolution - 30 krpm
Feed Speed - 25.4 mm/sec
Z-axis down speed - 5 mm/sec
Type of coolant - tap water
Cut mode - A (down cut)
Tape - 0.0889 mm thickness - Unitron Systems, Inc
Blade height - 0.3048 mm

The result for each example was a bumped die coated with solid underfill adhesive. The bumps were examined via optical microscopy and found to be completely covered and were not damaged, for both Example 1 and Example 2. Additionally, the dies were cross-sectioned and the cross-sections were examined via optical microscopy. For both examples the bumps were completely covered and were not damaged. A photo of a die prepared according to the inventive process using the formulation of Example 2 is shown in FIGURE 3. A photo of the cross-section of a die prepared according to the inventive process using the formulation of Example 2 is shown in FIGURE 4.

## Claims

1. A process for applying a wafer-level underfill comprising:
(i.) providing a solvent-free hot-melt underfill composition
(ii.) melting the underfill,
(iii.) applying the underfill in a uniform layer to the active side of a semiconductor wafer,
(iv.) returning the underfill to a solid state,
(v.) dicing the wafer into individual dies.

2. The process of Claim 1, wherein the underfill comprises one or more curable, polymerizable, or polymerized materials that are solid at room temperature and become liquid within the temperature range of 40°C and 300°C.

3. The process of Claim 2 wherein the underfill comprises an epoxy.

4. The process of Claim 2 wherein the underfill comprises at least 20 weight % filler.

5. The process of Claim 1 wherein the underfill is applied by stencil printing.

6. The process of Claim 1 further comprising heating the wafer prior to application of the underfill.

7. The process of Claim 1 wherein the excess underfill is removed by mechanical grinding.

8. The process of Claim 2 wherein the underfill is applied to a thickness of >200 µm.
